(19) Europäisches Patentamt
European Patent Office
Office européen des brevets

(11) **EP 0 646 885 B1**

(12) **EUROPÄISCHE PATENTSCHRIFT**

(45) Veröffentlichungstag und Bekanntmachung des Hinweises auf die Patenterteilung:
**23.05.2001 Patentblatt 2001/21**

(51) Int Cl.[7]: **G06F 17/50**, H01L 27/02

(21) Anmeldenummer: **94114515.3**

(22) Anmeldetag: **15.09.1994**

(54) **Simulationsverfahren für MOS-Schaltkreise**

Method for simulation of MOS circuits

Méthode de simulation de circuits MOS

(84) Benannte Vertragsstaaten:
**DE FR GB IT**

(30) Priorität: **01.10.1993 DE 4333601**

(43) Veröffentlichungstag der Anmeldung:
**05.04.1995 Patentblatt 1995/14**

(73) Patentinhaber: **Infineon Technologies AG**
**81669 München (DE)**

(72) Erfinder: **Miura-Mattausch, Mitiko**
**D-85649 Brunnthal (DE)**

(74) Vertreter: **Zedlitz, Peter, Dipl.-Inf. et al**
**Patentanwalt,**
**Postfach 22 13 17**
**80503 München (DE)**

(56) Entgegenhaltungen:
**US-A- 5 245 543**

- **ADVANCED RESEARCH IN VLSI. PROC. OF THE 1987 STANFORD CONFERENCE, 1987, CAMBRIDGE, MA, USA, Seiten 211-219, XP002019503 M.A. MAHER AND C.A. MEAD: "A Physical Charge-Controlled Model for MOS Transistors"**

**Beschreibung**

Moderne integrierte Schaltkreise umfassen häufig $10^6$ oder mehr Transistoren.

Zur Herstellung derartig komplexer integrierter Schaltkreise wird zunächst anhand einer funktionellen Beschreibung der Schaltung ein Schaltbild erstellt. Mit Hilfe eines Schaltkreissimulators werden die Eigenschaften der Schaltung berechnet. Bei Abweichungen des Schaltverhaltens von der geforderten funktionellen Beschreibung werden Änderungen des Schaltbildes vorgenommen und das geänderte Schaltbild wiederum im Schaltkreissimulator berechnet. Dieser Zyklus wird solange durchlaufen, bis die Eigenschaften des Schaltbildes mit den geforderten Spezifikationen übereinstimmen. Dann folgt die Erstellung eines Lay-outs. Anhand des Lay-outs werden die Masken für die Prozeßfolge erzeugt, in der der integrierte Schaltkreis schließlich realisiert wird.

In dem Schaltkreissimulator werden für MOS-Transistoren die relevanten elektrischen Schaltgrößen mit Hilfe eines Transistormodels für die Anschlußknoten des MOS-Transistors, das heißt Source, Drain, Gate, Substrat, berechnet. Wie gut das Schaltverhalten des am Ende realisierten integrierten Schaltkreises mit dem durch den Schaltkreissimulator Vorhergesagten übereinstimmt, hängt wesentlich von der Qualität des Transistormodells ab.

Zur Überprüfung von Transistormodellen werden Simulationsrechnungen von Ringoszillatoren mit Messungen der Ringoszillatoren verglichen. Es zeigt sich, daß die in Simulationsrechnungen bestimmten Ringoszillatorfrequenzen mit den Gemessenen nicht übereinstimmen. Die Diskrepanz wird mit zunehmender Reduktion der Strukturgrößen der MOS-Transistoren größer.

Es ist vorgeschlagen worden, durch Einführung von Fitparametern die Transistormodelle so zu ändern, daß sie die physikalischen Gegebenheiten auch bei reduzierter Strukturgröße der Transistoren und unterhalb des strong inversion-Gebietes realistisch wiedergeben (siehe zum Beispiel H. J. Park, "Charge sheet and non-quasistatic MOSFET models for SPICE", Ph. D. dissertation Memorandum No. UCB/ERL M89/20, Electronics Research Lab., Dep. EECS, University of California, Berkeley, Feb. 24, 1989).

Die Fitparameter werden durch den Vergleich von Simulationsrechnungen mit Messungen bestimmt. Dazu können Transientenmessungen erforderlich sein.

Da die erforderlichen Fitparameter unphysikalisch sind, lassen sich keine zuverlässigen Voraussagen für die Fitparameter für eine geänderte Transistortechnologie oder reduzierte Strukturgröße machen. Für jedes Transistordesign werden erneute Messungen erforderlich.

Der Erfindung liegt eine Aufgabe zugrunde, ein Verfahren zur Herstellung eines integierten Schaltkreises anzugeben, bei dem die Erstellung eines Entwurfs für den Schaltkreis unter Verwendung eines Schaltkreissimulators gesteuert wird, für den eine Anpassung von Fitparametern an Messungen nicht erforderlich ist.

In ADVANCED RESEARCH IN VLSI. PROC. OF THE 1987 STANFORD CONFERENCE, 1987, CAMBRIDGE, MA, USA, Seiten 211-219, M.A. MAHER, C.A. MEAD: 'A Physical Charge-Controlled Model for MOS Transistors' , und IEICE TRANS. ELECTRON. (Japan), Bd. E75-C, Nr. 2, Februar 1992, Japan, 172-180; M.MIURA-MATTAUSCH, U.WEINERT: "Unified MOSFET model for all channel lengths down to quarter micron" werden Transistormodelle verwendet, die den Drift- und den Diffusionsbeitrag zum Ladungsträgertransport und Kurzkanaleffekte berücksichtigen. Es ist eine weitere Aufgabe dieser Erfindung, die physikalischen Verhältnisse noch realistischer wiederzugeben.

Diese Aufgabe wird erfindungsgemäß gelöst durch ein Verfahren nach Anspruch 1. Das Transistormodell ist konsistent, das heißt es beschreibt die physikalischen Verhältnisse im Transistor, ohne daß Fitparameter erforderlich wären. Die Beweglichkeit $\mu$ der Ladungsträger kann aus einem Standardbeweglichkeitsmodell oder durch Messung des Stroms $I_{ds}$ zwischen Source und Drain bestimmt werden.

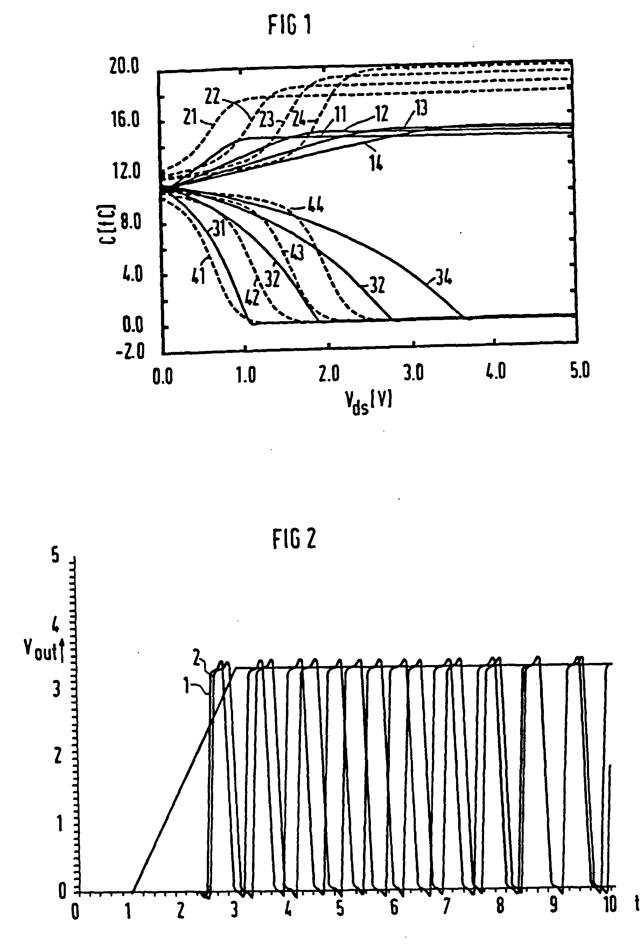

Figur 1 zeigt berechnete Kapazitäten für 0,65 $\mu$m Kanallänge in Abhängigkeit der angelegten Spannung zwischen Source und Drain $V_{ds}$. Die durchgezogen Kurven 11, 12, 13, 14 zeigen das Ergebnis der Berechnungen der Kapazität $C_{gs}$ zwischen Gate und Source nach dem Transistormodell, das in dem erfindungsgemäßen Verfahren verwendet wird, wobei die Spannung $V_{gs}$ zwischen Gate und Source 1, 2, 3 bzw. 4 Volt beträgt. Zum Vergleich zeigen die gestrichelten Kurven 21, 22, 23, 24 die entsprechenden Kapazitäten $C_{gs}$ nach einem Transistormodell, wie es in bekannten Verfahren verwendet wird und das den Diffusionsbeitrag und den Kurzkanaleffekt vernachlässigt. Die durchgezogenen Kurven 31, 32, 33, 34 zeigen das Ergebnis der Berechnung von Kapazitäten $C_{gd}$ zwischen Gate und Drain nach dem Transistormodell, das in dem erfindungsgemäßen Verfahren verwendet wird. Die Spannung $V_{gs}$ zwischen Gate und Source beträgt wiederum 1, 2, 3 bzw. 4 Volt. Zum Vergleich sind die gestrichelten Kurven 41 dargestellt, die wiederum die berechnete Kapazität $C_{gd}$ zwischen Gate und Drain nach einem konventionellen Transistormodell wiedergeben.

In Figur 2 ist die Antwortfunktion $V_{out}$ eines Ringoszillators in Abhängigkeit der Zeit t dargestellt. Die mit 1 bezeichnete Kurve ist dabei das Ergebnis einer Rechnung unter Verwendung des konsistenten Transistormodells, das in dem erfindungsgemäßen Verfahren verwendet wird. Die mit 2 bezeichnete Kurve zeigt das Ergebnis der Rechnung nach einem konventionellen Transistormodell.

Das in dem erfindungsgemäßen Verfahren verwendete konsistente Transistormodell geht aus von den Ladungen, die im Gate, in der Inversionsschicht, im Drain, im Source und im Substrat gespeichert sind. $Q_g$, $Q_i$, $Q_d$, $Q_s$ und $Q_b$ bezeichnet diese Ladungen pro Flächeneinheit. Für $Q_i$ und $Q_b$ gilt als Funktion des Ortes y entlang des Kanals:

$$Q_i(y) = -C_{ox}(V'_G - \phi_s(y)) - Q_b(y) \tag{1}$$

$$Q_b(y) = -qN_{sub}L_D\sqrt{2(\beta\phi_s(y)-1)} \tag{2}$$

Mit

$$V'_G = V_{gs} - V_{fb} - \Delta V'_G \tag{3}$$

$$\Delta V'_G = \frac{\varepsilon_{si}}{C_{ox}}\sqrt{\frac{2\varepsilon_{si}}{qN_{sub}}\phi_s}E_{yy} \tag{4}$$

$$\beta = \left(\frac{kT}{q}\right)^{-1} \tag{5}$$

Dabei ist $C_{ox}$ die Oxidkapazität, q die elektronische Ladung, $N_{sub}$ die Dotierstoffkonzentration im Substrat, $L_D$ die Debyelänge, $V_{fb}$ die flat-band-Voltage (Deutscher Ausdruck: Flach-Band-Spannung). $\phi_S$ ist das ortsabhängige Oberflächenpotential, das durch Lösen der Poissongleichung ermittelt wird. $\beta$ ist die thermische Spannung. $\varepsilon_{si}$ ist die Dielektrizitätskonstante von Silizium. $E_{yy}$ ist der Gradient des lateralen elektrischen Feldes. $V_{gs}$ ist die Spannung zwischen Gate und Source.

Der Therm $\Delta V'_G$ berücksichtigt den Kurzkanaleffekt. Bei Reduktion der Kanallänge wächst das laterale elektrische Feld, so daß das laterale elektrische Feld das vertikale elektrische Feld für Kurzkanaltransistoren sogar dominieren kann. In diesem Fall kann $E_{yy}$ nicht mehr vernachlässigt werden. Der Wert für $E_{yy}$ wird aus der gemessenen Schwellenspannung des MOS-Transistor ermittelt.

Die Gesamtladung $Q_I$ in der Inversionsschicht und $Q_B$ im Substrat wird durch Integration über die Kanalrichtung y von Source nach Drain berechnet:

$$Q_I = W\int_O^L Q_i(y)dy \tag{6}$$

$$Q_B = W\int_O^L Q_b(y)dy \tag{7}$$

Dabei ist W die Kanalweite und L die Kanallänge. Für die Gesamtladung auf dem Gate $Q_G$, Source $Q_S$ und Drain $Q_D$ gilt:

$$Q_G = -(Q_I + Q_B) \tag{8}$$

$$Q_I = Q_S + Q_D \tag{9}$$

Die Partitionierung von $Q_I$ in $Q_S$ und $Q_D$ wird entsprechend S.Y. Oh et al, IE EE J. Solid-State Circuits, SC 15, 1980, S. 636 - 643 durch folgende Gleichungen vorgenommen:

$$Q_D = W \int_O^L \frac{y}{L} Q_i(y) dy \qquad (10)$$

$$Q_S = W \int_O^L (1 - \frac{y}{L}) Q_i(y) dy \qquad (11)$$

Unter der Annahme, daß der Strom im Kanal entlang der Oberfläche fließt (charge-sheet approximation) gilt für den Strom $I_{ds}$ zwischen Drain und Source:

$$I_{ds} = -\frac{W\mu}{L} \int Q_i(y) \frac{d\phi_f(y)}{dy} dy \qquad (12)$$

mit

$$\frac{d\phi_f}{dy} = \frac{d\phi_S(y)}{dy} - \frac{1}{\beta} \frac{d \ln Q_i(y)}{dy} \qquad (13)$$

$$-Q_i(y) = qN(y) \qquad (14)$$

Dabei ist $\mu$ die Beweglichkeit der Ladungsträger. $\phi_f$ ist das quasi Fermipotential, das unter Berücksichtigung sowohl des Diffusions- als auch des Drift-Beitrags beschrieben wird. Der Term

$$\frac{d\phi_s(y)}{dy} \qquad (15)$$

beschreibt dabei den Beitrag durch Drift, der Term

$$\frac{1}{\beta} \frac{d \ln Q_{i(y)}}{dy} \qquad (16)$$

beschreibt den Diffusionsbeitrag.
N(y) ist die ortsabhängige Dotierstoffkonzentration in der Inversionsschicht.
Unter der Annahme, daß die Beweglichkeit $\mu$ unabhängig von der Position im Kanal ist gilt für den Drainstrom $I_{ds}$ in dem charge-sheet-Modell:

$$I_{ds}/\left(\frac{1}{\beta}\mu\frac{W}{L}\right)=C_{ox}\left(1+\beta V'_G\right)\left(\phi_{SL}-\phi_{SO}\right)-\frac{\beta}{2}C_{ox}\left(\phi_{SL}^2-\phi_{SO}^2\right) \qquad (17)$$

$$-qN_{sub}L_D\left(\frac{2\sqrt{2}}{3}\right)\left[\left(\beta\phi_{SL}-1\right)^{\frac{3}{2}}-\left(\beta\phi_{SO}-1\right)^{\frac{3}{2}}\right]$$

$$+qN_{sub}L_D\sqrt{2}\left[\left(\beta\phi_{SL}-1\right)^{\frac{1}{2}}-\left(\beta\phi_{SO}-1\right)^{\frac{1}{2}}\right]$$

Der Wert des Oberflächenpotentials auf der Sourceseite $\phi_{S0}$ und des Oberflächenpotentials auf der Drainseite $\phi_{SL}$ wird durch Lösung der Poissongleichung und Gleichung 13 berechnet.

Durch algebraische Umformungen lassen sich die Gleichungen für die Gesamtladungen Q als Funktionen von $\phi_{S0}$ und $\phi_{SL}$ schreiben.

Die Beweglichkeit $\mu$ kann aus einem Standardbeweglichkeitsmodel oder aus gemessenen Kennlinien der MOS-Transistoren ermittelt werden.

Die für die Schaltkreissimulation erforderlichen Größen $I_{ds}$ sowie die Gesamtladungen Q und die intrinsischen Kapazitäten, die die Ableitungen der Ladung am Anschlußknoten nach den angelegten Spannungen $V_{gs}$ zwischen Gate und Source, $V_{ds}$ zwischen Drain und Source und $V_{bs}$ zwischen Substrat und Source sind, werden durch algebraische Umformung als analytische Ausdrücke geschrieben, die Funktionen von $\phi_{S0}$ und $\phi_{SL}$ sind. $\phi_{S0}$ und $\phi_{SL}$ sind direkt abhängig von technologischen Parametern wie der Oxiddicke $T_{ox}$ und der Dotierstoffkonzentration im Substrat $N_{sub}$.

**Patentansprüche**

1. Verfahren zur Herstellung eines integrierten Schaltkreises,

   - bei dem ein Entwurf für den Schaltkreis, der mehrere MOS-Transistoren umfaßt, erstellt wird,

   - bei dem die Erstellung des Entwurfs für den Schaltkreis unter Verwendung eines Schaltkreissimulators gesteuert wird,

   - bei dem in dem Schaltkreissimulator für die Anschlußknoten der MOS-Transistoren unter Vorgabe von den Spannungen zwischen Gate und Source $V_{gs}$, zwischen Drain und Source $V_{ds}$ und zwischen dem Substrat und Source $V_{bs}$ der Drainstrom $I_{ds}$, die Gesamtladungen Q jeweils für die Anschlußknoten Source, Drain, Gate und Substrat sowie für die Inversionsschicht, die Ableitungen $\frac{\partial I_{ds}}{\partial V}$ und die Ableitungen $\frac{\partial Q}{\partial V}$ durch Lösung folgender Gleichungen berechnet wird:

$$Q_i(y) = -C_{ox}(V'_G-\phi_s(y))-Q_b(y) \qquad (1)$$

$$Q_b(y) = -qN_{sub}L_D\sqrt{2(\beta\phi_s(y)-1)} \qquad (2)$$

Mit

$$V'_G = V_{gs} - V_{fb} - \Delta V'_G \qquad (3)$$

$$\Delta V'_G = \frac{\varepsilon_{si}}{C_{ox}}\sqrt{\frac{2\varepsilon_{si}}{qN_{sub}}\phi_s}E_{yy} \qquad (4)$$

$$\beta = \left(\frac{kT}{q}\right)^{-1} \tag{5}$$

$$Q_I = W \int_O^L Q_i(y)dy \tag{6}$$

$$Q_B = W \int_O^L Q_b(y)dy \tag{7}$$

$$Q_G = -(Q_I + Q_B) \tag{8}$$

$$Q_I = Q_S + Q_D \tag{9}$$

$$Q_D = W \int_O^L \frac{y}{L} Q_i(y)dy \tag{10}$$

$$Q_S = W \int_O^L (1-\frac{y}{L})Q_i(y)dy \tag{11}$$

$$I_{ds} = -\frac{W\mu}{L} \int Q_i(y) \frac{d\phi_f(y)}{dy}dy \tag{12}$$

$$\frac{d\phi_f}{dy} = \frac{d\phi_S(y)}{dy} - \frac{1}{\beta} \frac{d \ln Q_i(y)}{dy} \tag{13}$$

$$-Q_i(y) = qN(y) \tag{14}$$

Dabei ist

$C_{ox}$ die Oxidkapazität
$\phi_S(y)$ das Oberflächenpotential
q die elektronische Ladung
$N_{sub}$ die Dotierstoffkonzentration im Substrat
$L_D$ die Debyelänge
$V_{fb}$ die flat-band-Voltage
$Q_i(y)$, $Q_b(y)$ die ortsabhängigen Ladungen in der Inversionsschicht bzw. dem Substrat pro Flächeneinheit
$V_{gs}$ die Spannung zwischen Gate und Source
$\varepsilon_{Si}$ die Elektrizitätskonstante von Silizium
$E_{yy}$ der Gradient des lateralen elektrischen Feldes im Kanal

$\beta$ die thermische Spannung

$Q_I$, $Q_B$, $Q_G$, $Q_S$, $Q_D$ die Gesamtladung in der Inversionsschicht, dem Substrat, dem Gate, Source bzw. Drain

W die Kanalweite

L die Kanallänge

$I_{ds}$ der Drainstrom

$\phi_f$ das Quasifermipotential

N(y) die ortsabhängige Dotierstoffkonzentration im Kanal.

2.  Verfahren nach Anspruch 1,
    bei dem die Beweglichkeit $\mu$ aus einem Standardbeweglichkeitsmodel berechnet wird.

3.  Verfahren nach Anspruch 1,
    bei dem zur Bestimmung der Beweglichkeit $\mu$ die Strom-Spannungskennlinie $I_{ds}(V_{gs}, V_{ds}, V_{bs})$ eines MOS-Transistors gemessen wird und $\mu$ unter der Annahme, daß $\mu$ im Kanal des MOS-Transistors ortsabhängig ist, aus

$$I_{ds/}\left(\frac{1}{\beta}\mu\frac{W}{L}\right) = C_{ox}(1+\beta V'_G)(\phi_{SL} - \phi_{SO}) - \frac{\beta}{2}C_{ox}\left(\phi^2_{SL} - \phi^2_{SO}\right) \qquad (17)$$

$$-qN_{sub}L_D\left(\frac{2\sqrt{2}}{3}\right)\left[(\beta\phi_{SL} - 1)^{\frac{3}{2}} - (\beta\phi_{SO} - 1)^{\frac{3}{2}}\right]$$

$$+qN_{sub}L_D\sqrt{2}\left[(\beta\phi_{SL} - 1)^{\frac{1}{2}} - (\beta\phi_{SO} - 1)^{\frac{1}{2}}\right]$$

berechnet wird, wobei $\phi_{S0}$ das Oberflächenpotential auf der Sourceseite und $\phi_{SL}$ das Oberflächenpotential auf der Drainseite ist.

**Claims**

1.  Method for fabricating an integrated circuit,

    -   in which a design is created for the circuit, which comprises a plurality of MOS transistors,
    -   in which the creation of the design for the circuit is controlled using a circuit simulator,
    -   in which, in the circuit simulator, for the terminal nodes of the MOS transistors, given specification of the voltages between gate and source $V_{gs}$, between drain and source $V_{ds}$ and between the substrate and source $V_{bs}$, the drain current $I_{ds}$, the total charges Q in each case for the terminal nodes source, drain, gate and substrate and also for the inversion layer, the derivatives $\frac{\partial I_{ds}}{\partial V}$ and the derivatives $\frac{\partial Q}{\partial V}$ are calculated by solving the following equations:

$$Q_i(y) = -C_{ox}(V'_G - \phi_s(y)) - Q_b(y) \qquad (1)$$

$$Q_b(y) = -qN_{sub}L_D\sqrt{2(\beta\phi_s(y)-1)} \qquad (2)$$

where

$$V'_G = V_{gs} - V_{fb} - \Delta V'_G \qquad (3)$$

$$\Delta V'_G = \frac{\varepsilon_{si}}{C_{ox}} \sqrt{\frac{2\varepsilon_{si}}{qN_{sub}}} \phi_s E_{yy} \qquad (4)$$

$$\beta = \left(\frac{kT}{q}\right)^{-1} \qquad (5)$$

$$Q_I = W \int_O^L Q_i(y) dy \qquad (6)$$

$$Q_B = W \int_O^L Q_b(y) dy \qquad (7)$$

$$Q_G = -(Q_I + Q_B) \qquad (8)$$

$$Q_I = Q_S + Q_D \qquad (9)$$

$$Q_D = W \int_O^L \frac{y}{L} Q_i(y) dy \qquad (10)$$

$$Q_S = W \int_O^L (1 - \frac{y}{L}) Q_i(y) dy \qquad (11)$$

$$I_{ds} = -\frac{W\mu}{L} \int Q_i(y) \frac{d\phi_f(y)}{dy} dy \qquad (12)$$

$$\frac{d\phi_f}{dy} = \frac{d\phi_S(y)}{dy} - \frac{1}{\beta} \frac{d \ln Q_i(y)}{dy} \qquad (13)$$

$$-Q_i(y) = qN(y) \qquad (14)$$

In this case,

$C_{ox}$ is the oxide capacitance
$\varphi_s(y)$ is the surface potential
q is the electronic charge

$N_{sub}$ is the dopant concentration in the substrate

$L_D$ is the Debye length

$V_{fb}$ is the flat-band voltage

$Q_i(y)$, $Q_b(y)$ are the location-dependent charges in the inversion layer and the substrate, respectively, per unit area

$V_{gs}$ is the voltage between gate and source

$\varepsilon_{si}$ is the dielectric constant of silicon

$E_{yy}$ is the gradient of the lateral electric field in the channel

$\beta$ is the thermal voltage

$Q_I$, $Q_B$, $Q_G$, $Q_S$, $Q_D$ is the total charge in the inversion layer, the substrate, the gate, source and drain, respectively

W is the channel width

L is the channel length

$I_{ds}$ is the drain current

$\phi_f$ is the quasi-Fermi potential

$N(y)$ is the location-dependent dopant concentration in the channel.

**2.** Method according to Claim 1,
in which the mobility $\mu$ is calculated from a standard mobility model.

**3.** Method according to Claim 1,
in which, in order to determine the mobility $\mu$, the current-voltage characteristic $I_{ds}$ ($V_{gs}$, $V_{ds}$, $V_{bs}$) of a MOS transistor is measured and, assuming that $\mu$ is location-dependent in the channel of the MOS transistor, $\mu$ is calculated from

$$I_{ds}/\left(\frac{1}{\beta}\mu\frac{W}{L}\right) = C_{ox}(1+\beta V'_G)(\phi_{SL}-\phi_{SO}) - \frac{\beta}{2}C_{ox}\left(\phi_{SL}^2 - \phi_{SO}^2\right) \qquad (17)$$

$$-qN_{sub}L_D\left(\frac{2\sqrt{2}}{3}\right)\left[(\beta\phi_{SL}-1)^{\frac{3}{2}} - (\beta\phi_{SO}-1)^{\frac{3}{2}}\right]$$

$$+qN_{sub}L_D\sqrt{2}\left[(\beta\phi_{SL}-1)^{\frac{1}{2}} - (\beta\phi_{SO}-1)^{\frac{1}{2}}\right]$$

where $\phi_{SO}$ is the surface potential on the source side and $\phi_{SL}$ is the surface potential on the drain side.

**Revendications**

**1.** Procédé de fabrication d'un circuit intégré,

- dans lequel on produit une ébauche pour le circuit qui comprend plusieurs transistors MOS,
- dans lequel on commande la production de l'ébauche pour le circuit en utilisant un simulateur de circuit,
- dans lequel on calcule dans le simulateur de circuit, pour les points nodaux de raccordement des transistors MOS, avec la donnée des tensions $V_{gs}$ entre grille et source, $V_{ds}$ entre drain et source et $V_{bs}$ entre substrat et source, le courant $I_{ds}$ de source, les charges Q totales chaque fois pour les points nodaux source, drain, grille et substrat, ainsi que pour la couche d'inversion, les dérivés $\frac{\partial I_{ds}}{\partial V}$ et les dérivés $\frac{\partial Q}{\partial V}$, en résolvant les équations suivantes :

$$Q_i(y) = -C_{ox}(V'_G - \phi_S(y)) - Q_b(y) \qquad (1)$$

$$Q_b(y) = -qN_{sub}L_D\sqrt{2(\beta\phi_s(y)-1)} \qquad (2)$$

avec

$$V'_G = V_{gs} - V_{fb} - \Delta V'_G \tag{3}$$

$$\Delta V'_G = \frac{\varepsilon_{si}}{C_{OX}} \sqrt{\frac{2\varepsilon_{si}}{qN_{sub}} \phi_s} Eyy \tag{4}$$

$$\beta = \left(\frac{kT}{q}\right)^{-1} \tag{5}$$

$$Q_I = W \int_0^L Q_i(y) dy \tag{6}$$

$$Q_B = W \int_0^L Q_b(y) dy \tag{7}$$

$$Q_G = -(Q_I + Q_B) \tag{8}$$

$$Q_I = Q_S + Q_D \tag{9}$$

$$Q_D = W \int_0^L \frac{y}{L} Q_i(y) dy \tag{10}$$

$$Q_s = W \int_0^L (1 - \frac{y}{L}) Q_i(y) dy \tag{11}$$

$$I_{ds} = -\frac{W\mu}{L} \int Q_i(y) \frac{d\phi_f(y)}{dy} dy \tag{12}$$

$$\frac{d\phi_f}{dy} = \frac{d\phi_s(y)}{dy} - \frac{1}{\beta} \frac{d\ln Q_i(y)}{dy} \tag{13}$$

$$-Q_I(y) = qN(y) \tag{14}$$

En l'occurrence,

$C_{ox}$ est la capacité d'oxyde

$\phi_S(y)$ le potentiel de surface

q la charge électronique

$N_{sub}$ la concentration en substance dopante dans le substrat

$L_D$ la longueur de Debye

$V_{fb}$ la tension de large bande

$Q_i(y)$, $Q_b(y)$ les charges en fonction du lieu dans la couche d'inversion et dans le substrat par unité de surface

$V_{gs}$ la tension entre grille et source

$\varepsilon_{si}$ la constante diélectrique du silicium

$E_{yy}$ le gradient du champ électrique latéral dans le canal

$\beta$ la contrainte thermique

$Q_I$, $Q_B$, $Q_G$, $Q_S$, $Q_D$ la charge totale dans la couche d'inversion, le substrat, la grille, la source et le drain

W la largeur de canal

L la longueur de canal

$I_{ds}$ le courant de drain

$\phi_f$ le quasi potentiel de Fermi

N(y) la concentration en substance dopante en fonction du lieu dans le canal.

2. Procédé suivant la revendication 1, dans lequel on calcule la mobilité $\mu$ à partir d'un modèle de mobilité normalisé.

3. Procédé suivant la revendication 1, dans lequel, pour déterminer la mobilité $\mu$, on mesure la courbe $I_{ds}$ ($V_{gs}$, $V_{ds}$, $V_{bs}$) caractéristique courant-tension d'un transistor MOS et on calcule $\mu$ en faisant l'hypothèse que $\mu$, dans le canal du transistor MOS, dépend du lieu, par

$$I_{ds} \left/ \left( \frac{1}{\beta} \mu \frac{W}{L} \right) = C_{OX}(1 + \beta V'_G)(\phi_{SL} - \phi_{SO}) - \frac{\beta}{2} C_{OX}(\phi_{SL}^2 - \phi_{SO}^2) \right. \quad (17)$$

$$- qN_{sub}L_D \left( \frac{2\sqrt{2}}{3} \right) \left[ (\beta\phi_{SL} - 1)^{\frac{3}{2}} - (\beta\phi_{SO} - 1)^{\frac{3}{2}} \right]$$

$$+ qN_{sub}L_D \sqrt{2} \left[ (\beta\phi_{SL} - 1)^{\frac{1}{2}} - (\beta\phi_{SO} - 1)^{\frac{1}{2}} \right]$$

$\phi_{S0}$ étant le potentiel de surface du côté de la source et $\phi_{SL}$ le potentiel de surface du côté du drain.

## FIG 1

## FIG 2